# DEMANDE DE BREVET EUROPEEN

(11) **EP 1 821 110 A2**
(43) Date de publication de la demande: **22.08.2007**
(21) Numéro de dépôt: 07101085.4
(22) Date de dépôt: 24.01.2007
(51) Int. Cl.: G01R 31/305

(54) **Dispositif de test de connexions électriques, sans contact**

(30) Priorité: 17.02.2006 FR 0601385
(71) Demandeur: COMMISSARIAT A L'ENERGIE ATOMIQUE, 75015 Paris (FR)
(72) Inventeur: Demars, Patrick, 38950 Quaix en Chartreuse (FR)
(74) Mandataire: Guérin, Michel

(57) **Abrégé**

L'invention concerne le test sans contact de substrats portant des connexions électriques denses ("chip-carriers" et autres). Le test est sans contact en ce sens qu'une injection ou une extraction d'électrons dans les conducteurs à tester est obtenue par un effet d'arrachage d'électrons sous l'influence d'un faisceau d'ultraviolets.

Le dispositif de test comprend une plaque de collecte d'électrons conformée en réseau d'électrodes (281, 282, 283, 284) individuellement adressables, pouvant être portées à un potentiel positif ou négatif pour réaliser une injection ou une extraction d'électrons. Une capacité est associée à chaque électrode. L'électrode individuelle est réalisée en forme de grille conductrice ajourée constituant une première armature de la capacité. L'autre armature (481, 482, 483, 484) est constituée par une grille ajourée située à l'aplomb de la première.

## Description

L'invention concerne le test, sans contact, de caractéristiques électriques de composants électroniques, telles que l'isolement entre conducteurs, la continuité électrique de conducteurs, la résistance, voire même la capacité et l'inductance. Le test est sans contact en ce sens qu'une injection ou une extraction d'électrons dans les conducteurs à tester est obtenue par un effet d'arrachage d'électrons sous l'influence d'un faisceau électromagnétique (en principe un faisceau de rayons ultraviolets) ayant une énergie de photon supérieure à l'énergie d'extraction d'un électron hors du conducteur.

Les dispositifs de test sans contact sont principalement destinés à vérifier les interconnexions électriques dans des supports d'interconnexions tels que des circuits imprimés ou, surtout, des substrats de support de circuits intégrés (en anglais "chip-carriers") à très grand nombre de bornes de sortie. Avec la diminution des dimensions des circuits intégrés et l'accroissement de la densité des connexions, le test électrique devient difficile et ne peut plus s'effectuer par contact direct entre des pointes de test et les plages conductrices à tester.

Typiquement, pour monter un circuit intégré sur un circuit imprimé, on interpose un substrat d'interconnexion ("chip-carrier"), ayant des centaines de plages de contact très denses du côté qui reçoit une puce de circuit intégré à très grand nombre de contacts, et ayant un nombre souvent plus réduit de plages de contact à l'arrière, du côté qui sera soudé sur le circuit imprimé. Autant il est possible d'appliquer des pointes de test du côté arrière, sous forme de ce qu'on appelle un "lit à clous", c'est-à-dire une matrice de pointes de contact adressable, parce que la densité de contact est plus faible, autant il est presque impossible de le faire du côté qui porte la puce. On a donc développé des systèmes de test sans contact pour permettre le test du substrat d'interconnexion à partir du côté qui porte la puce. Le test peut d'ailleurs se faire de manière mixte avec des pointes de test (ou un autre mode d'accès par contact direct) sur la face arrière moins dense, et un test sans contact sur la face avant plus dense.

On a déjà proposé des dispositifs de test sans contact capables soit d'extraire des électrons d'un conducteur à tester, soit d'injecter des électrons dans ce conducteur, soit enfin de faire une opération d'extraction et une opération d'injection simultanément sur deux portions de conducteur pour tester l'isolement, la continuité, ou la résistance entre ces deux portions. La demande de brevet WO 01/38892, le brevet US 4 573 008, décrivent de tels dispositifs.

Le principe de ce test est rappelé brièvement ici :
- pour l'extraction d'électrons, un faisceau étroit de rayons ultraviolets est dirigé très précisément sur une portion de conducteur du substrat d'interconnexion à tester, par exemple une plage de contact destinée à être soudée ultérieurement à une puce de circuit intégré ; des électrons sont arrachés de ce conducteur, et sont attirés vers un collecteur (on parlera ci-après d'électrode de collecte) porté à un potentiel suffisamment positif ; le conducteur se charge positivement en perdant des électrons. II peut se charger positivement jusqu'au potentiel de l'électrode de collecte ;
- pour l'injection d'électrons, un faisceau ultraviolet est dirigé vers une électrode d'émission, arrachant des électrons à celle-ci ; les électrons sont attirés par un conducteur du substrat à tester, à condition que celui-ci soit à un potentiel suffisamment positif par rapport à l'électrode d'émission ; le conducteur se charge négativement en recueillant les électrons, éventuellement jusqu'au potentiel de l'électrode de l'électrode d'émission.

Ces deux possibilités de charge, positive ou négative, permettent différents tests d'isolement électrique entre deux conducteurs, de continuité électrique de deux portions d'un même conducteur, de résistance d'un conducteur, et même d'inductance et de capacité, et ceci sans contact.

Alternativement, pour un test impliquant à la fois un conducteur de la face avant et un conducteur de la face arrière du substrat à tester, on peut prévoir de charger un conducteur sans contact du côté où les conducteurs sont plus denses et d'appliquer un potentiel par contact direct du côté où les conducteurs, moins denses, sont plus facilement accessibles.

On s'intéressera ici au côté où les conducteurs sont chargés ou déchargés sans contact.

Pour pouvoir extraire ou injecter des électrons dans n'importe quelle portion de conducteur du substrat à tester, on prévoit de préférence que les électrodes sont agencées sous forme d'un réseau matriciel de lignes et colonnes de petites électrodes élémentaires individuelles, isolées les unes des autres et adressables sélectivement pour pouvoir être portées individuellement à un potentiel désiré soit négatif soit positif selon qu'on veut en extraire des électrons ou y injecter des électrons. Les électrodes de collecte et d'émission sont alors constituées exactement de la même manière, mais elles jouent un rôle de collecte ou d'émission selon le potentiel auquel elles sont portées. Dans la suite on parlera uniquement d'électrodes de collecte pour simplifier, sachant qu'elles jouent indifféremment le rôle de collecte ou d'émission, et on appellera plaque de collecte la plaque qui porte le réseau d'électrodes adressables.

Pour mesurer les caractéristiques d'isolement ou de continuité électrique des conducteurs du substrat, on associe par ailleurs à chaque électrode individuelle de collecte une capacité de mesure. La capacité de mesure sert à la fois à maintenir pendant un certain temps une tension de polarisation de l'électrode de collecte et à stocker les charges électriques déplacées au moment de l'extraction ou injection d'électrons, en vue d'une lecture de ces charges (ultérieurement ou simultanément).

Par exemple, la capacité de mesure peut dans un premier temps être portée à un potentiel de référence et dans un deuxième temps être connectée à un circuit de lecture de charges ; le circuit de lecture de charges va mesurer la perte de charge éventuelle due à un défaut d'isolement entre deux points.

La plaque de collecte comporte donc au moins
- un réseau d'électrodes de collecte associées chacune à une capacité locale,
- et un circuit d'adressage en ligne et en colonne pour d'une part appliquer des potentiels désirés aux électrodes ou à la capacité et d'autre part lire des potentiels présents sur les électrodes et la capacité.

Le circuit d'adressage comprend des bus d'un ou plusieurs conducteurs de ligne, des bus d'un ou plusieurs conducteurs de colonne, et, localement à proximité de chaque électrode individuelle, une circuiterie de quelques transistors reliés à ces bus ; les bus et transistors sont déposés en couche mince (transistors dits TFT de l'anglais "thin-film transistors") sur la plaque qui est à la fois électriquement isolante et transparente au rayonnement électromagnétique (en principe rayons ultraviolet) utilisé.

Le réseau d'électrodes et la circuiterie associée à chaque électrode, capacité, transistors et connexions conductrices, occupent une place importante sur la plaque de collecte. Or le faisceau électromagnétique qui sert à bombarder soit une électrode soit un conducteur du substrat à tester est appliqué à travers la plaque de collecte car la source électromagnétique ne peut pas être disposée dans l'intervalle étroit entre la plaque de collecte et le substrat à tester : si le substrat à tester est situé au-dessous de la plaque de collecte, alors la source de rayonnement est située au-dessus de la plaque. Les éléments présents sur la plaque de collecte nuisent donc à la transparence de la plaque et gênent le passage du faisceau vers le conducteur à charger ou décharger.

Pour faciliter ce passage du faisceau, on prévoit tout d'abord que les électrodes sont réalisées sous forme d'une grille conductrice ajourée.

De plus, selon l'invention, on prévoit que la capacité associée à chaque électrode individuelle soit réalisée par une première armature constituée par l'électrode elle-même, en forme de grille conductrice ajourée, et par une deuxième armature constituée par une autre grille conductrice ajourée, située au-dessous de la première grille et séparée d'elle par une couche de matériau diélectrique.

Par conséquent, on propose selon l'invention un dispositif de test sans contact d'un substrat comportant des connexions conductrices, le dispositif comportant une plaque de collecte pourvue d'un réseau d'électrodes individuelles associées chacune à une capacité locale et pourvue de circuits d'adressage pour porter une électrode choisie et la capacité associée à des potentiels désirés et/ou pour mesurer le potentiel des électrodes ou de la capacité, et une source d'illumination électromagnétique apte à illuminer une zone ponctuelle d'une connexion conductrice du substrat pour réaliser une extraction d'électrons de cette zone ou une injection d'électrons dans cette zone, chaque électrode individuelle étant réalisée sous forme d'une grille conductrice ajourée, une première armature de la capacité comprenant la grille ajourée, et une deuxième armature de la capacité comprenant une deuxième grille conductrice ajourée située en-vis-à-vis de la première grille et séparée d'elle par une couche de matériau diélectrique.

Par la superposition de deux grilles ajourées formant à la fois l'électrode de collecte et la capacité de mesure qui lui est associée, on maximise la transparence de la plaque de collecte vis-à-vis du faisceau d'illumination, sans réduire trop la valeur de la capacité.

L'extraction d'électrons d'une connexion conductrice du substrat à tester se fait de préférence par illumination directe de cette connexion à travers la plaque de collecte, le potentiel d'au moins une électrode de collecte en vis-à-vis de la zone ponctuelle illuminée étant plus positif que celui de la connexion.

L'injection d'électrons se fait de préférence par illumination de cette connexion conductrice à travers la plaque de collecte, réflexion du faisceau sur la connexion vers au moins une électrode de collecte, et extraction d'électrons de cette électrode par le faisceau réfléchi, le potentiel de l'électrode illuminée par réflexion étant plus négatif que le potentiel de la connexion conductrice illuminée.

D'autres caractéristiques et avantages de l'invention apparaîtront à la lecture de la description détaillée qui suit et qui est faite en référence aux dessins annexés dans lesquels :
- la figure 1 représente un schéma du dispositif de test selon l'invention ;
- la figure2 représente un détail de l'injection de charge sur une plage de contact conductrice d'un substrat d'interconnexion à tester ;
- la figure 3 représente une vue de dessus correspondant à la figure 2 ;
- la figure 4 représente un schéma synoptique des circuits d'adressage et de mesure du dispositif de test selon l'invention ;
- la figure 5 représente un détail de réalisation de la plaque de collecte à électrodes adressables avec la capacité de mesure associée à chaque électrode de collecte individuelle.

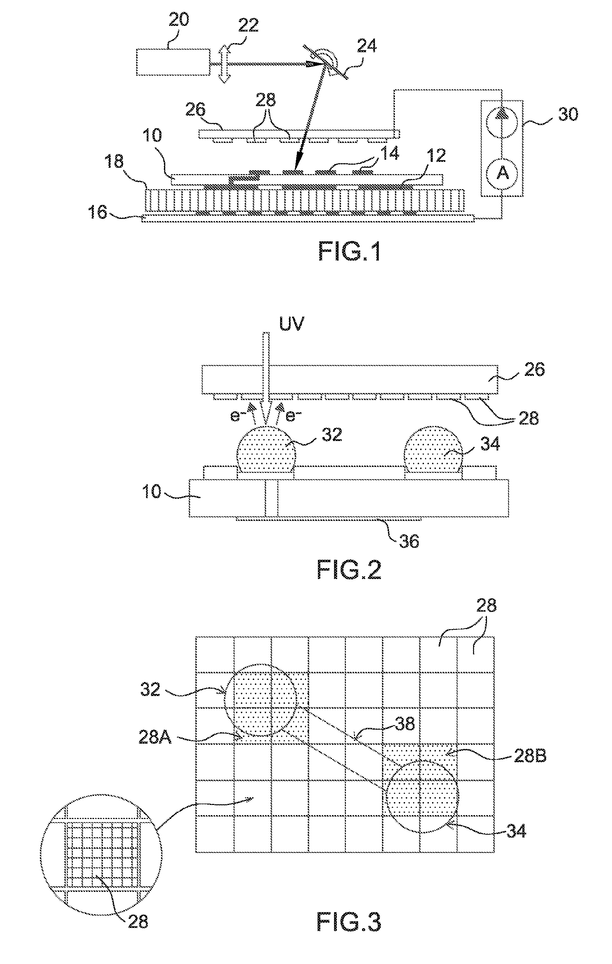

Le principe général d'un test sans contact est schématiquement représenté à la figure 1. Le substrat à tester est désigné par la référence 10 ; c'est par exemple un substrat d'interconnexion multicouche de type connu sous le nom de "chip carrier", à multiples interconnexions entre une face arrière (en bas sur la figure) et une face avant (en haut sur la figure). La face arrière est destinée à être soudée sur un circuit imprimé et la face avant est destinée à recevoir une puce de circuit intégré. Les connexions de la face arrière sont désignées par 12. Elles comprennent principalement des plages de soudure permettant de souder directement le substrat sur un circuit imprimé. Les connexions de la face avant, plus denses que celles de la face arrière, sont désignées par 14. Ces connexions 14 comprennent principalement des plots de contact, ou plages de soudure, permettant de relier par soudure directe cette plage à un plot de sortie d'une puce de circuit intégré (soudure de type "flip-chip", c'est-à-dire puce retournée face contre son support). Dans ce qui suit on parlera indifféremment, pour la face arrière comme pour la face avant, de conducteurs, ou de connexions conductrices ou de plages de soudure ou encore de plots de contact, étant entendu que le test envisagé vise à tester de manière générale n'importe quel conducteur électrique accessible par ces faces, mais que le plus souvent on effectuera le test sur des plots de contact. Les plots de contact ou plages de soudure de la face avant comportent par exemple chacune une bille de soudure à l'indium.

Le test à effectuer peut comprendre :
- des tests d'isolement ou de continuité électrique entre deux conducteurs de la face avant ; éventuellement des tests de résistivité, de capacité, d'inductance entre ces conducteurs ;
- des tests similaires (isolement, continuité, etc.) entre un conducteur de la face avant et un conducteur de la face arrière.

Dans ce qui suit, on considère que si des conducteurs de la face arrière interviennent dans le test, alors on accède à ces conducteurs par des contacts électriques directs par pointes de test ou autres, du fait que la densité des conducteurs de la face arrière le permet. Par conséquent, on ne s'intéressera qu'à l'accès, sans contact, aux conducteurs de la face avant, mais on comprend que si la densité de conducteurs de la face arrière l'exige, on peut aussi utiliser un accès électrique sans contact pour les connexions de la face arrière.

On a donc représenté, du côté de la face arrière, un réseau d'adressage 16 permettant d'établir une liaison électrique par contact physique direct ou indirect avec une plage de soudure 12 de la face arrière. Le réseau d'adressage 16 peut être relié aux plots de contact de face arrière par l'intermédiaire d'une nappe de prises de contact 18 constituée soit par un lit de pointes de test soit par une simple couche à conduction anisotrope : cette couche à conduction anisotrope établit une liaison de courant électrique dans le sens vertical (transversalement à la couche) mais pas dans le sens horizontal, de sorte que si un conducteur du réseau 16 est alimenté en tension, cette tension sera appliquée à un plot de contact 12 situé au-dessus de ce conducteur, mais pas à d'autres plots de contact. On peut ainsi, pour un test qui implique un conducteur de la face arrière, appliquer un potentiel désiré par adressage de ce conducteur à partir du réseau 16, et lire un courant traversant ce conducteur pendant le test.

Du côté de la face avant, le test est sans contact : une source de rayonnement électromagnétique 20, de préférence de la lumière ultraviolette, associée à une optique de focalisation 22 et une optique de renvoi 24 (par exemple un miroir orientable commandé), dirige un pinceau étroit sur une zone ponctuelle choisie d'un conducteur à tester. La machine de test est commandée par programme pour illuminer successivement, par une commande appropriée du miroir, les milliers de points qu'on doit en général tester dans un substrat d'interconnexion. L'énergie du rayonnement arrache des électrons au conducteur. Ces électrons sont attirés par une plaque de collecte 26 portée à un potentiel plus positif que le potentiel du conducteur illuminé. Le conducteur se charge ainsi à un potentiel positif au fur et à mesure que les électrons sont extraits, exactement comme si on faisait circuler un courant dans le conducteur. On peut mesurer le courant à ce stade ou à un stade ultérieur, ou mesurer le potentiel du conducteur à ce stade ou à un stade ultérieur.

La plaque de collecte 26 est placée à proximité immédiate du substrat à tester, pour éviter d'avoir à appliquer des potentiels trop élevés pour produire le champ électrique qui va attirer les électrons vers la plaque de collecte. L'intervalle entre le substrat et la plaque est un intervalle sous vide poussé, pour que les électrons circulent librement. La plaque de collecte est placée entre la source de rayonnement ultraviolet et le substrat à tester. Elle est en partie transparente au rayonnement, c'est-à-dire que sa surface n'est pas entièrement occupée par les électrodes de collecte.

Par ailleurs, pour permettre de mieux localiser le parcours des électrons entre un conducteur frappé par le faisceau ultraviolet et la plaque de collecte 26, on prévoit que cette dernière est divisée en un réseau de très nombreuses électrodes de collecte 28 qui peuvent être adressées individuellement. Chaque électrode fait par exemple quelques dizaines de micromètres de côté et la plaque de collecte peut comporter un réseau de plusieurs centaines d'électrodes en ligne et plusieurs centaines d'électrodes en colonne. Ainsi, par adressage en ligne et en colonne, il est possible de porter une ou plusieurs électrode de collecte, localisées en face d'un conducteur de substrat à charger positivement, à un potentiel positif ; les électrodes de collecte voisines peuvent même être portées à un potentiel négatif pour repousser les électrons qui pourraient se diriger vers elles. Les moyens d'adressage des électrodes de collecte ne sont pas représentés.

Pour laisser passer le faisceau ultraviolet, on prévoit que les électrodes de collecte sont constituées chacune sous forme d'une grille ajourée. Ceci n'est pas représenté sur la figure 1 compte tenu de l'échelle du dessin.

Comme le test peut nécessiter non seulement d'extraire des électrons d'un conducteur du substrat à tester, pour le charger positivement, mais aussi d'injecter des électrons dans le conducteur pour le charger négativement, on prévoit aussi la disposition suivante : le faisceau de lumière ultraviolette peut bombarder aussi de manière indirecte une électrode de collecte individuelle, chargée à un potentiel plus négatif que le conducteur à tester. Ceci extrait des électrons de l'électrode et ces électrons sont attirés vers le conducteur à tester, réalisant ainsi une injection d'électrons dans le conducteur. Le bombardement indirect consiste à faire réfléchir une partie du faisceau d'ultraviolets sur le conducteur à tester, le rayonnement réfléchi bombardant lui-même une électrode de collecte située immédiatement en vis-à-vis. Le conducteur du substrat, placé à un potentiel plus négatif que l'électrode qui a émis les électrons, recueille ces derniers. Certes des électrons sont arrachés du conducteur lors de son illumination mais ils retombent sur le conducteur, n'étant pas attirés par une électrode de collecte dès lors que les électrodes de collecte sont à un potentiel suffisamment négatif. On comprend que là encore, la plaque de collecte doit être suffisamment transparente pour que le faisceau ultraviolet puisse frapper les conducteurs et qu'une portion suffisante soit réfléchie vers une électrode de collecte.

Il est ainsi possible d'injecter des électrons dans un conducteur en même temps qu'on extrait des électrons de ce même conducteur ou d'un autre conducteur puisque les potentiels des électrodes individuelles sont commandables séparément (à condition bien sûr de pouvoir illuminer simultanément deux zones ponctuelles du substrat). Cela permet de tester un isolement ou une continuité électrique par mesure du courant qui circule entre le point où les électrons sont injectés et le point où ils sont extraits.

Les circuits d'adressage des électrodes de collecte et les circuits d'adressage des conducteurs à l'arrière du substrat d'interconnexion ne sont pas représentés. Sous la référence 30, on a représenté symboliquement un circuit de mesure de courant circulant entre un conducteur de la face arrière et un conducteur de la face avant du substrat d'interconnexion. Mais on peut aussi bien faire une mesure de courant entre deux conducteurs de la face avant, ou encore stocker dans une capacité une charge écoulée pendant une injection d'électrons ou une extraction d'électrons et lire ensuite la charge stockée.

Sur les figures 2 et 3, on a représenté de manière plus réaliste une portion de substrat 10 à tester avec, sur la face avant du substrat, deux conducteurs sous forme de deux plages de soudure comportant chacune une bille de soudure 32 et 34 respectivement (billes d'indium ou autres). Le conducteur de gauche 32 est relié à un conducteur 36 de face arrière du substrat, de sorte qu'il est possible de choisir le potentiel auquel on le porte par le réseau d'adressage 16 de la figure 1. Le conducteur de droite 34 n'est pas relié à un conducteur de face arrière et c'est par le faisceau ultraviolet qu'on lui injecte ou extrait des électrons. Cette figure montre qu'on peut, en extrayant des électrons du plot de contact 32, vérifier que ce plot est bien connecté au conducteur 36 de face arrière, par simple mesure du courant circulant dans le circuit de mesure 30 de la figure 1. Mais on peut comprendre qu'on peut aussi faire des mesures d'isolement entre un plot tel que 32 et un plot tel que 34, ou encore des mesures sur deux plots tels que 34, non connectés à un plot de face arrière. Le réseau dense d'électrodes de collecte 28 est visible sous la plaque de collecte 26.

La figure 3 est une vue de dessus montrant à la fois la configuration des deux plots de contact 32 et 34 avec leurs billes et la configuration du réseau d'électrodes 28 en damier, en vis-à-vis de ces plots. Une électrode individuelle correspond à un carré du damier et chaque électrode individuelle peut être portée à un potentiel choisi indépendamment du potentiel des autres électrodes.

Sur les figures 2 et 3, chaque électrode individuelle est représentée comme étant pleine pour simplifier la figure. En réalité chaque électrode est constituée sous forme d'une grille conductrice ajourée en raison de la nécessité d'une transparence au rayonnement de la source 20. De plus, sur la figure 3, le damier d'électrodes semble couvrir pratiquement toute la surface de la plaque de collecte. En réalité les électrodes n'occupent qu'une partie de cette surface : des conducteurs de ligne et des conducteurs de colonne doivent être insérés entre les rangées horizontales et verticales d'électrodes, et chaque électrode individuelle est associée localement à un circuit d'aiguillage à quelques transistors qui permet à la fois la sélection d'une électrode individuelle (au croisement d'une ligne et d'une colonne du réseau) et le choix d'un potentiel à appliquer à cette électrode. Ces éléments, conducteurs de ligne et de colonne et transistors du circuit d'adressage ne sont pas représentés sur les figures 2 et 3 compte-tenu de l'échelle de ces figures mais ils occupent une partie de la surface de la plaque de collecte. Enfin, à chaque électrode individuelle est associée une capacité de mesure, également non représentée sur les figures 2 et 3, disposée localement dans la zone correspondant à une électrode individuelle, c'est-à-dire dans un carré du damier. Cette capacité est reliée électriquement à l'électrode de collecte individuelle qui lui est associée.

Selon l'invention, comme on l'expliquera plus loin, cette capacité comprend deux armatures dont l'une est l'électrode elle-même en forme de grille ajourée et dont l'autre est aussi une grille ajourée située au-dessous de l'électrode et en regard de celle-ci.

La figure 3 permet de comprendre comment on va appliquer des potentiels aux électrodes de collecte, en fonction de leur position par rapport aux zones conductrices ponctuelles dans lesquelles on veut injecter ou extraire des électrons : pour extraire des électrons par exemple du plot conducteur 32 dont la surface représente quelques électrodes adjacentes, on va porter les quelques électrodes individuelles qui sont en vis-à-vis de ce plot à un potentiel positif ; ici ce sont quatre électrodes représentées en grisé et désignées par la référence globale 28A ; les électrodes qui les entourent peuvent rester à un potentiel nul ou même être portées à un potentiel négatif ; inversement, pour injecter des électrons, on porterait les électrodes à un potentiel négatif, et on laisserait les électrodes environnantes à un potentiel nul, voire positif ; par exemple quatre électrodes désignées globalement par la référence 28B et placées en vis-à-vis du plot conducteur 34 peuvent être portées à un potentiel négatif. On peut par exemple tester ainsi la présence désirable ou indésirable, ou les caractéristiques, d'un chemin conducteur entre les plots 32 et 34, figuré symboliquement sous la référence 38 sur la figure 3.

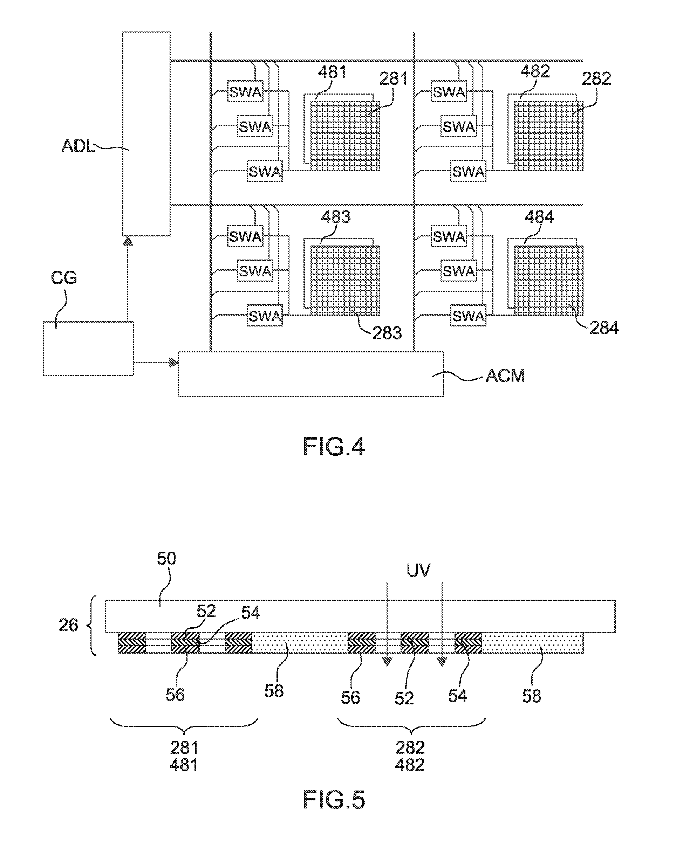

La figure 4 représente schématiquement la circuiterie électrique qui correspond à ce qui vient d'être décrit. On a représenté seulement deux lignes et deux colonnes d'électrodes, soit quatre électrodes individuelles en tout. Les électrodes sont désignées par 281 et 282 pour la première ligne, 283 et 284 pour la deuxième ligne. Elles sont dessinées sous forme d'un damier pour signifier qu'elles sont constituées par des grilles ajourées. Derrière chaque électrode on a représenté une deuxième armature de capacité, respectivement 481, 482, 483, 484. Cette deuxième armature n'est pas représentée sous forme d'un damier pour ne pas rendre le dessin confus, mais elle est bien constituée par une grille ajourée de dessin identique à celui de l'électrode de collecte. Les deux grilles sont séparées électriquement par une couche diélectrique non représentée sur la figure 4.

A chaque électrode individuelle est associé localement un circuit d'aiguillage individuel. Dans l'exemple représenté, on a considéré que ce circuit d'aiguillage comporte trois interrupteurs analogiques désignés par la référence SWA, qui peuvent être réalisés chacun par un transistor en couche mince (transistors TFT). De manière générale, tous les circuits électriques formés sur la plaque de collection peuvent être constitués de circuits en couche mince. Par ailleurs, pour l'adressage des électrodes individuelles, on a prévu, sur la plaque de collecte 26, des bus de conducteurs en ligne et en colonne, situés entre les lignes et colonnes d'électrodes. Les interrupteurs SWA sont commandés par les conducteurs du bus de ligne ; ils permettent de connecter, par les bus de colonne, la première ou la deuxième armature de la capacité à la circuiterie d'adressage extérieure au réseau d'électrodes, pour:
- appliquer des potentiels choisis à l'une et l'autre des armatures d'une part,
- mesurer le potentiel des électrodes ou lire des charges stockées dans la capacité d'autre part.

On a représenté sur la figure 4 un circuit d'adressage de ligne ADL qui commande les conducteurs des bus de ligne pour rendre simultanément conducteurs les transistors raccordés à un conducteur choisi, et un circuit d'adressage et de mesure ACM qui sélectionne les conducteurs du bus de colonne pour leur appliquer des potentiels ou pour y lire des potentiels ou des circulations de charges électriques. Un contrôleur général CG contrôle le fonctionnement global de l'ensemble de la circuiterie présente sur la plaque de collecte 26.

Enfin, la figure 5 permet de comprendre comment la capacité de mesure est réalisée par la superposition de deux grilles ajourées séparées par une couche diélectrique. La plaque de collecte est par exemple une plaque de verre 50 sur laquelle sont formés, par des techniques de dépôt et gravure en couche mince, à la fois les électrodes, la capacité, les circuits d'aiguillage individuels, les conducteurs des bus de ligne et de colonne, et d'autres éléments de circuit éventuellement. Sur la figure 5, on a représenté deux électrodes adjacentes 281 et 282 et les armatures de capacité correspondantes 481 et 482 et on a supposé pour simplifier que les grilles ajourées ne comportent que trois barreaux chacune.

La plaque de collecte 26 comprend par exemple un support isolant électriquement et transparent aux rayons ultraviolets, par exemple une plaque de verre 50. Sur cette plaque de verre sont déposés et gravés successivement une couche conductrice 52 constituant les armatures 481 et 482 de la capacité, une couche diélectrique 54, et une couche conductrice 56 constituant les électrodes de collecte 281, 282 qui elles-mêmes constituent l'autre armature des capacités. Les couches conductrices 52 et 56 peuvent être en métal (aluminium, cuivre, tungstène ou alliage métallique par exemple) gravé en forme de grille ajourée. La couche diélectrique 54 peut être en oxyde ou nitrure de silicium par exemple). La gravure des deux couches conductrices est telle que l'électrode de collecte en forme de grille ajourée vient exactement au-dessus de la première grille ajourée en restant séparée d'elle par la couche diélectrique. Les deux couches conductrices peuvent être réalisées avec le même matériau. Dans les zones ajourées, il n'y a pas d'obstacle au passage du rayonnement ultraviolet, de sorte qu'une fraction importante du faisceau ultraviolet peut traverser la plaque pour atteindre un conducteur du substrat à tester au-dessous de la plaque.

En dehors des zones réservées à la grille ajourée, on place les autres éléments de circuit : transistors et conducteurs de lignes et colonnes. Ces éléments sont localisés dans des zones désignées par 58 sur la figure 5. Ces zones peuvent être de taille réduite puisqu'elles ne comportent pas de capacité de mesure. Les deux armatures de la capacité sont reliées, par les interrupteurs du circuit d'aiguillage, à des conducteurs de colonne.

Dans un exemple d'utilisation du dispositif de test selon l'invention, on peut tester l'isolement entre deux conducteurs de la face avant du substrat d'interconnexion. Le procédé qui suit est donné seulement à titre d'exemple.

On donne d'abord aux conducteurs à tester un potentiel de référence (potentiel de masse par exemple), ce qui peut être fait par un moyen conventionnel tel qu'un balai de carbone frotté sur la face avant du substrat à tester. Puis on effectue les opérations suivantes : on porte le premier conducteur à un potentiel positif Vp en éjectant des électrons de ce conducteur par illumination ultraviolette directe à travers la plaque de collecte, une première électrode de collecte (au moins), située en regard du premier conducteur, étant portée à un potentiel positif et les électrodes voisines restant à un potentiel nul ou négatif. On porte ensuite, après un laps de temps prédéterminé, le second conducteur au même potentiel positif Vp en injectant des électrons dans ce conducteur, par illumination ultraviolette directe du second conducteur, une électrode de collecte au moins, située en regard du second conducteur, étant portée à un potentiel positif, les autres à un potentiel négatif. Au cours de cette charge négative du second conducteur, on mesure la quantité de charges qui circule de l'électrode de collecte au second conducteur. Si elle est égale à une valeur de référence obtenue par étalonnage préalable, cela veut dire qu'au moment de la deuxième illumination, le second conducteur était toujours au potentiel de référence et qu'il n'a pas subi l'influence du potentiel positif du premier conducteur. Si au contraire la quantité de charges est inférieure à cette valeur de référence, voire même si elle est nulle, c'est que le potentiel du second conducteur a augmenté sous l'influence de la charge du premier conducteur, montrant un défaut d'isolement entre les deux conducteurs. En fonction de l'intervalle de temps choisi, du potentiel choisi, et de la quantité de charges mesurée, on peut déterminer une résistance de fuite entre les conducteurs et déterminer si le substrat d'interconnexion doit être considéré comme défectueux.

Dans un autre exemple d'utilisation, on teste la continuité électrique entre deux conducteurs de la face avant du substrat. Cette opération suppose qu'on dispose de deux sources ultraviolettes pour illuminer séparément les deux conducteurs. On charge le premier conducteur à un potentiel positif Vp par rapport au potentiel de référence, et le deuxième à un potentiel négatif. La charge positive se fait par illumination directe du premier conducteur, au moins une première électrode de collecte, au-dessus du conducteur, étant portée à un potentiel positif, et les électrodes environnantes étant à un potentiel négatif. Et la charge négative se fait par illumination indirecte d'une électrode de collecte située au-dessus du second conducteur et portée à un potentiel négatif (les électrodes environnantes étant à un potentiel positif) ; l'illumination indirecte se fait par réflexion du faisceau ultraviolet sur le second conducteur.

Les charges d'électrons circulant dans les électrodes au cours de cette double illumination sont mesurées pour la première électrode et la deuxième électrode. L'analyse des charges, comparée à des abaques d'étalonnage, fournit des indications sur la résistance électrique présente entre les premier et second conducteurs.

D'autres méthodes d'utilisation du dispositif peuvent être envisagées : par exemple, pour tester l'isolement d'un conducteur par rapport au reste du substrat on peut simplement charger ce conducteur par extraction d'électrons sous illumination, jusqu'à une tension positive (tous les autres ayant été préalablement portés à zéro) ; on regarde
- si le courant de charge finit par s'annuler au bout d'un certain temps, montrant qu'il n'y a pas de fuite de courant significative empêchant la charge du conducteur au potentiel positif ;
- ou si au contraire un courant de charge persiste, montrant qu'il y a un défaut d'isolement.

## Revendications

1. Dispositif de test sans contact d'un substrat (10) comportant des connexions conductrices (14, 32, 34), le dispositif comportant une plaque de collecte (26) pourvue d'un réseau d'électrodes individuelles associées chacune à une capacité locale et pourvue de circuits d'adressage pour porter une électrode choisie et la capacité associée à des potentiels désirés et/ou pour mesurer le potentiel des électrodes ou de la capacité, et une source d'illumination électromagnétique (20) apte à illuminer une zone ponctuelle d'une connexion conductrice du substrat pour réaliser une extraction d'électrons de cette zone ou une injection d'électrons dans cette zone, chaque électrode individuelle (281, 282) étant réalisée sous forme d'une grille conductrice ajourée, cette grille ajourée servant de première armature (481, 482) de la capacité, et une deuxième armature de la capacité comprenant une deuxième grille conductrice ajourée (52) située en vis-à-vis de la première grille et séparée d'elle par une couche de matériau diélectrique (54).

2. Dispositif de test sans contact selon la revendication 1, **caractérisé en ce qu'**il comporte des moyens pour illuminer une zone ponctuelle d'un conducteur du substrat à tester et des moyens pour porter à un potentiel plus positif que le conducteur au moins une électrode individuelle située au-dessus de ce conducteur.

3. Dispositif de test sans contact selon la revendication 1, **caractérisé en ce qu'**il comporte des moyens pour porter à un potentiel plus négatif que le conducteur au moins une électrode individuelle située au-dessus de ce conducteur.

4. Dispositif de test sans contact selon l'une des revendications 1 à 3, **caractérisé en ce que** la source de rayonnement est une source de rayons ultraviolets.
